(19) Europäisches Patentamt / European Patent Office / Office européen des brevets

(11) **EP 3 829 267 A1**

(12) **EUROPEAN PATENT APPLICATION**
published in accordance with Art. 153(4) EPC

(43) Date of publication:
**02.06.2021 Bulletin 2021/22**

(51) Int Cl.:
**H05B 33/10** (2006.01)   **H01L 51/50** (2006.01)
**H05B 33/02** (2006.01)

(21) Application number: **19841332.0**

(22) Date of filing: **22.07.2019**

(86) International application number:
**PCT/JP2019/028711**

(87) International publication number:
**WO 2020/022289 (30.01.2020 Gazette 2020/05)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
**KH MA MD TN**

(30) Priority: **23.07.2018 JP 2018137764**

(71) Applicant: **SUMITOMO CHEMICAL COMPANY LIMITED**
**Chuo-ku**
**Tokyo 104-8260 (JP)**

(72) Inventor: **YOSHIOKA Hidemi**
**Niihama-shi, Ehime 792-0015 (JP)**

(74) Representative: **J A Kemp LLP**
**14 South Square**
**Gray's Inn**
**London WC1R 5JJ (GB)**

(54) **METHOD FOR MANUFACTURING ORGANIC ELECTRONIC DEVICE**

(57)    A method for manufacturing an organic electronic device according to an embodiment includes: an organic function layer formation step of forming an organic function layer having a monolayer structure or a multilayer structure on a first electrode layer formed on a long flexible film 10; and a second electrode layer formation step of forming a second electrode layer on the organic function layer, in which the organic function layer formation step includes a coating layer formation step of forming a coating layer 181a by a coating method, and a heating step of heating the coating layer with infrared rays to obtain a function layer, while conveying the flexible film by a roll 28 whose surface 28a is made of an infrared absorbing material, and an average absorption rate of infrared rays in a wavelength range of 3 μm to 10 μm in the infrared absorbing material is 0.8 or more.

FIG.5

# Description

## TECHNICAL FIELD

The present invention relates to a method for manufacturing an organic electronic device.

## BACKGROUND ART

Conventional technologies in the present technical field include a method for manufacturing an organic electronic device having, on a flexible transparent base (flexible film), a transparent electrode (first electrode layer) and at least one organic layer (function layer) that is formed by a roll-to-roll wet coating method (See Patent Document 1).

## PRIOR ART DOCUMENTS

## PATENT DOCUMENTS

Patent Document 1: International Publication No. 2010/090087

## SUMMARY OF THE INVENTION

## PROBLEMS TO BE SOLVED BY THE INVENTION

As described in Patent Document 1, in the case of forming a function layer included in an organic electronic device by a roll-to-roll wet coating method, a coating layer is first formed on a flexible film, and then a heating step of heating the coating layer while conveying the flexible film by a conveyance roll is performed. The conveyance roll is normally a metal roll. Therefore, when the flexible film warmed in the heating step is brought into contact with the conveyance roll, the temperature of the flexible film rapidly decreases at the contact portion. As a result, the flexible film is twisted and wrinkled. When the flexible film is twisted and wrinkled, film thickness unevenness occurs in the coating layer before heated and dried, and the function layer cannot be formed to a desired thickness.

Thus, it is an object of the present invention to provide a method for manufacturing an organic electronic device in which at least one function layer included in an organic function layer can be easily formed to a desired thickness.

## MEANS FOR SOLVING THE PROBLEMS

The method for manufacturing an organic electronic device according to an aspect of the present invention includes: an organic function layer formation step of forming an organic function layer having a monolayer structure or a multilayer structure on a first electrode layer formed on a long flexible film; and a second electrode layer formation step of forming a second electrode layer on the organic function layer. The organic function layer formation step includes: a coating layer formation step of forming a coating layer by a coating method; and a heating step of heating the coating layer with infrared rays to obtain a function layer, while conveying the flexible film by a roll whose surface is made of an infrared absorbing material. The average absorption rate of infrared rays in the wavelength range of 3 $\mu$m to 10 $\mu$m in the infrared absorbing material is 0.8 or more.

In the above method for manufacturing, the organic function layer formation step has the coating layer formation step and the heating step, and in the heating step, the coating layer is heated by infrared rays. Therefore, film thickness unevenness is less likely to occur in the coating layer than in a case of using warm air. Furthermore, in the heating step, since the flexible film is conveyed by the roll, the roll surface is heated by infrared rays. Therefore, even if the flexible film comes into contact with the roll, the temperature of the contact portion is hardly lowered, and it is hence possible to prevent the flexible film from being twisted and wrinkled. As a result, the function layer can be formed to a desired thickness.

The roll may have a metal roll body and a coating layer coated on the surface of the roll body. The material of the coating layer can be the infrared absorbing material.

In the above-described heating step, the flexible film may be heated to 100°C or higher. When the flexible film is heated to the temperature of 100°C or higher, wrinkles or the like are likely to occur if a temperature drop occurs in a part of the flexible film. Therefore, the method for manufacturing the organic electronic device is more effective in the case where the flexible film is heated to 100°C or higher in the heating step.

In the above-described heating step, the wind velocity within 10 mm from the surface of the flexible film on which the first electrode layer is formed may be 0.1 m/s or less. Thus, the coating layer is less likely to have film thickness unevenness, and the function layer of a desired thickness can be easily formed.

The infrared absorbing material can be an inorganic oxide. In this case, durability can be secured. An example of the inorganic oxide is alumina.

The coating method may be an ink-jet printing method. The viscosity of the ink for use in the ink-jet printing method is relatively low. Therefore, the thickness of the coating layer formed by, for example, an ink-jet printing method is susceptible to unevenness caused by twisting, wrinkling, or the like of the flexible film. Therefore, as described above, the method for manufacturing the organic electronic device in which the occurrence of twisting and wrinkling of the flexible film is suppressed in the heating step is more effective when the coating method is the ink-jet printing method.

## EFFECT OF THE INVENTION

According to the present invention, it is possible to provide a method for manufacturing an organic electronic device in which at least one function layer included in an organic function layer can be easily formed to a desired thickness.

BRIEF DESCRIPTION OF THE DRAWINGS

Fig. 1 is a plan view of a long flexible film for use in a method for manufacturing an organic EL device (organic electronic device) according to an embodiment.
Fig. 2 is a view schematically showing a method for manufacturing an organic EL device by a roll-to-roll method.
Fig. 3 is a schematic view roughly showing the configuration of a manufactured organic EL device (organic electronic device).
Fig. 4 is a view for explaining an organic function layer formation step.
Fig. 5 is a view for explaining the heating step included in the organic function layer formation step.

MODE FOR CARRYING OUT THE INVENTION

Embodiments of the present invention will be described below with reference to the drawings. Identical elements are given the identical reference numerals, and redundant description is omitted. The dimension proportions of the drawings do not necessarily match those described. Examples of the organic electronic device include an organic EL device, an organic solar cell, and an organic photodetector. In the embodiments described below, unless otherwise stated, the organic electronic device is an organic EL device, and in particular, a method for manufacturing a bottom-emission type organic EL device will be described.

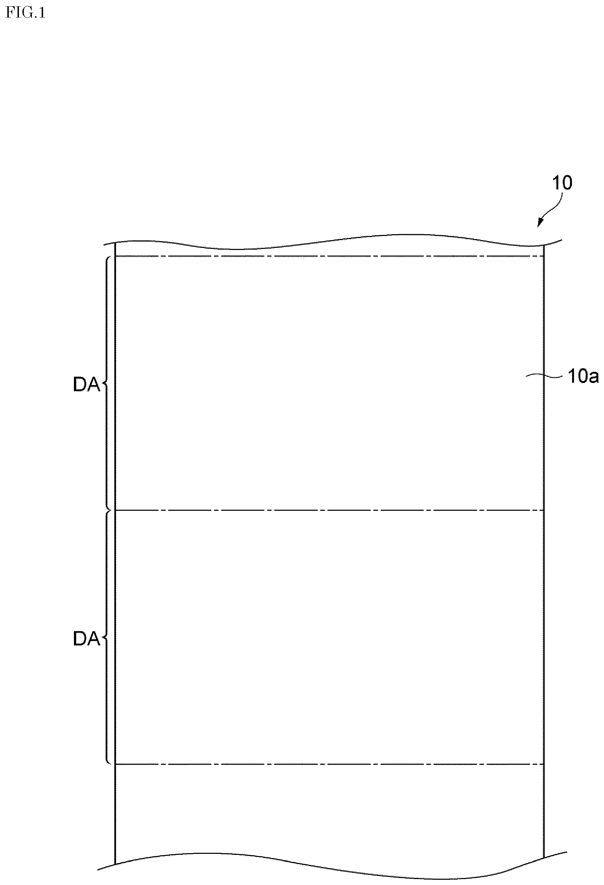

Fig. 1 is a plan view of a long flexible film 10 for use in a method for manufacturing an organic EL device according to an embodiment. In the present description, the long flexible film 10 refers to a flexible film extending in one direction, the length of which in the extending direction (i.e., longitudinal direction) is longer than the length of which in a direction (width direction) orthogonal to the longitudinal direction. Here, the flexible film is a film having flexibility. Flexibility is a property of being capable of bending an object (film in the present description) without shearing or breaking even when a predetermined force is applied to the object.

The flexible film 10 is translucent to at least visible light (light having a wavelength of 400 nm to 800 nm). The thickness of the flexible film 10 is 30 $\mu$m or more and 500 $\mu$m or less, for example.

The flexible film 10 is a resin film such as a plastic film. Examples of the material of the flexible film 10 include polyether sulfone (PES); polyester resin such as polyethylene terephthalate (PET) and polyethylene naphthalate (PEN); polyolefin resin such as polyethylene (PE), polypropylene (PP), and cyclic polyolefin; polyamide resin; polycarbonate resin; polystyrene resin; polyvinyl alcohol resin; saponified ethylene-vinyl acetate copolymer; polyacrylonitrile resin; acetal resin; polyimide resin; and epoxy resin.

Among the above resins, the material of the flexible film 10 is preferably a polyester resin or a polyolefin resin, and more preferably a polyethylene terephthalate or a polyethylene naphthalate because of high heat resistance, low linear expansion coefficient, and low manufacturing cost. One of these resins may be used alone, or two or more of these resins may be used in combination.

On a surface 10a of the flexible film 10, a barrier layer (in particular, a barrier layer that provides a moisture barrier) for blocking gas, moisture, and the like may be disposed.

In manufacturing an organic EL device, a plurality of device formation areas DA is virtually set in the longitudinal direction of the long flexible film 10, and an anode layer (first electrode layer), an organic function layer, a cathode layer (second electrode layer), and the like are formed on the device formation areas DA. In a mode where the barrier layer is formed on the surface 10a of the flexible film 10, an anode layer, an organic function layer, a cathode layer, and the like are formed on the barrier layer.

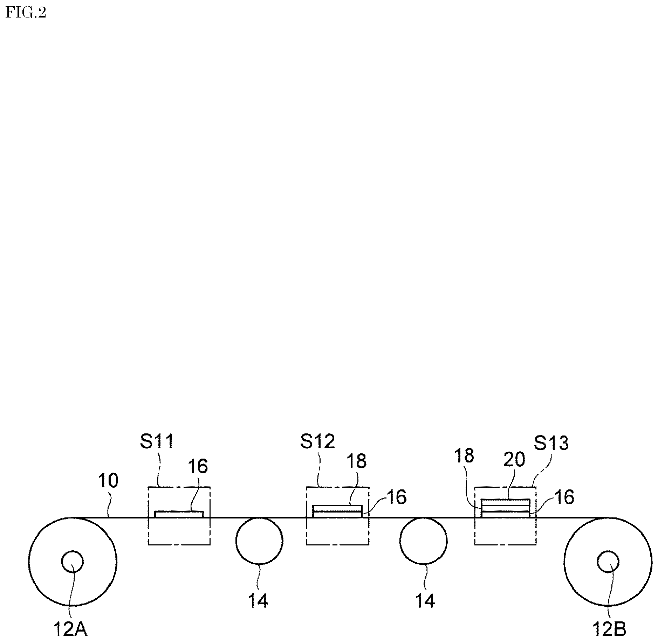

Fig. 2 is a conceptual view of a method for manufacturing an organic EL device using a roll-to-roll method, which is a method for manufacturing an organic EL device according to an embodiment. In a case where an organic EL device is manufactured by the roll-to-roll method, the roll-like flexible film 10 is set in a feeding part 12A to feed the flexible film 10. An anode layer formation step (first electrode layer formation step) S11, an organic function layer formation step S12, and a cathode layer formation step (second electrode layer formation step) S13 are sequentially performed while the fed flexible film 10 is conveyed by a conveyance roll 14 toward a winding part 12B. Thereafter, the flexible film 10 is wound in a roll shape by the winding part 12B. The feeding part 12A, the winding part 12B, and the conveyance roll 14 can be parts of the conveyance mechanism of the flexible film 10. The conveyance mechanism can include other known components such as a tension adjustment mechanism. Each step can be provided with a winding step and a feeding step. Furthermore, after the flexible film 10 is once wound and stored in each step, the flexible film 10 can be fed again to perform a next step.

[Anode layer formation step]

In the anode layer formation step S11, an anode layer (first electrode layer) 16 is formed in each of the plurality of device formation areas DA virtually set along the longitudinal direction of the flexible film 10. Thus, the anode layer 16 is formed discretely along the longitudinal direction of the flexible film 10. The anode layer 16 may have a network structure in which conductors (e.g., metal) are formed in a network shape. Examples of the thickness of the anode layer 16 are normally 10 nm to 10 μm, preferably 20 nm to 1 μm, and more preferably 50 nm to 500 nm.

The anode layer 16 can be formed by a dry film forming method, a plating method, a coating method, for example. Examples of the dry film forming method include a vacuum deposition method, a sputtering method, an ion plating method, a CVD method. The coating method is a method for forming a layer using a liquid in which the material of the layer to be formed is dissolved in a solvent. Examples of the coating method include a microgravure coating method, a gravure coating method, a bar coating method, a roll coating method, a wire bar coating method, a spray coating method, a screen printing method, a flexographic printing method, an offset printing method, a nozzle printing method, and an ink-jet printing method.

[Organic function layer formation step]

In the organic function layer formation step S12, an organic function layer 18 is formed on the anode layer 16 formed on the flexible film 10. The organic function layer 18 is a device function part that contributes to light emission of the organic EL device such as charge transfer and charge recombination in accordance with electric power applied to the organic EL device. The organic function layer 18 has a light-emitting layer, which is an organic layer.

The light-emitting layer is a function layer having a function of emitting light of a predetermined wavelength. The thickness of the light-emitting layer has an optimum value varying depending on the material to be used, and is appropriately set so that the driving voltage and the light-emitting efficiency have appropriate values. The thickness of the light-emitting layer is, for example, 1 nm to 1 μm, preferably 2 nm to 500 nm, and more preferably 10 nm to 200 nm.

The light-emitting layer normally includes a light-emitting material that primarily emits at least one of fluorescence and phosphorescence, or the light-emitting material and an auxiliary dopant material for the light-emitting layer. The organic substance contained in the light-emitting material emitting at least one of fluorescence and phosphorescence may be a low-molecular compound or a high-molecular compound. Examples of the light-emitting material include the following pigment materials, metal complex materials, and polymer materials.

(Pigment material)

Examples of the pigment material include cyclopendamine and its derivatives, tetraphenylbutadiene and its derivatives, triphenylamine and its derivatives, oxadiazole and its derivatives, pyrazoloquinoline and its derivatives, distyrylbenzene and its derivatives, distyrylarylene and its derivatives, pyrrole and its derivatives, thiophene compounds, pyridine compounds, perinone and its derivatives, perylene and its derivatives, oligothiophene and its derivatives, oxadiazole dimer, pyrazoline dimer, quinacridone and its derivatives, and coumarin and its derivatives.

(Metal complex material)

Examples of the metal complex material include a rare earth metal such as Tb, Eu, and Dy, or a metal complex having Al, Zn, Be, Pt, Ir, or the like as a central metal and having oxadiazole, thiadiazole, phenylpyridine, phenylbenzimidazole, quinoline structure, or the like as a ligand. Examples of the metal complex include a metal complex having light emission from a triplet excited state such as an iridium complex and a platinum complex, an aluminum quinolinol complex, a benzoquinolinol beryllium complex, a benzoxazolyl zinc complex, a benzothiazole zinc complex, an azomethyl zinc complex, a porphyrin zinc complex, and a phenanthroline europium complex.

(Polymer material)

Examples of the polymer material include polyparaphenylene vinylene and its derivatives, polythiophene and its derivatives, polyparaphenylene and its derivatives, polysilane and its derivatives, polyacetylene and its derivatives, polyfluorene and its derivatives, polyvinylcarbazole and its derivatives, and materials obtained by polymerizing the pigment material or metal complex material.

The dopant material for the light-emitting layer is added, for example, to improve the light-emitting efficiency or to change the light-emitting wavelength. Examples of the dopant material for the light-emitting layer include perylene and its derivatives, coumarin and its derivatives, rubrene and its derivatives, quinacridone and its derivatives, squalium and its derivatives, porphyrin and its derivatives, styryl pigments, tetracene and its derivatives, pyrazolone and its derivatives, decacyclene and its derivatives, and phenoxazone and its derivatives.

The organic function layer 18 may have a multilayer structure including a function layer other than the light-emitting layer. Examples of the function layer that can be provided between the anode layer and the light-emitting layer include a hole injection layer and a hole transport layer. Examples of the function layer that can be provided between the cathode layer and the light-emitting layer include an electron injection layer and an electron transport layer. Examples of the layer structure that can be adopted by an organic function layer are shown below. In the following examples of the layer structure, the anode layer and the cathode layer are also in parentheses for the purpose of explanation.

(a) (Anode layer)/Light-emitting layer/(Cathode layer)

(b) (Anode layer)/Hole Injection Layer/Light-emitting layer/(Cathode layer)

(c) (Anode layer)/Hole injection layer/Light-emitting layer/Electron injection layer/(Cathode layer)

(d) (Anode layer)/Hole injection layer/Light-emitting layer/Electron transport layer/Electron injection layer/(Cathode layer)

(e) (Anode layer)/Hole injection layer/Hole transport layer/Light-emitting layer/(Cathode layer)

(f) (Anode layer)/Hole injection layer/Hole transport layer/Light-emitting layer/Electron injection layer/(Cathode layer)

(g) (Anode layer)/Hole injection layer/Hole transport layer/Light-emitting layer/Electron transport layer/Electron injection layer/(Cathode layer)

(h) (Anode layer)/Light-emitting layer/Electron injection layer/(Cathode layer)

(i) (Anode layer)/Light-emitting layer/Electron transport layer/Electron injection layer/(Cathode layer)

The symbol "/" indicates that the layers before and after the symbol "/" are laminated adjacently. The mode of the configuration example (a) is an example in a case where the organic function layer 18 has a monolayer structure composed of a light-emitting layer.

Known materials can be used for the hole injection layer, the hole transport layer, the electron injection layer, and the electron transport layer. Normally, the hole transport layer and the electron transport layer are organic layers. The hole injection layer and the electron injection layer may be an organic layer or an inorganic layer. The electron injection layer may be a part of the cathode layer, for example. The thickness of the hole injection layer, the hole transport layer, the electron injection layer, and the electron transport layer can be appropriately set in consideration of electrical characteristics, ease of film formation, and the like. The thickness of the hole injection layer, the hole transport layer, the electron injection layer, and the electron transport layer is on the order of submicrons.

The function layer constituting the organic function layer 18 can be formed by a coating method. Examples of the coating method can be similar to those exemplified in the description of the anode layer formation step S11. In the case where the organic function layer 18 has a multilayer structure, each function layer is only required to be formed in order from the anode layer 16 side.

[Cathode layer formation step]

In the cathode layer formation step S13, a cathode layer (second electrode layer) 20 is formed on the organic function layer 18. A part of the cathode layer 20 may be formed also on the flexible film 10. In order to reflect the light from the organic function layer 18 on the cathode layer 20 and send it to the anode layer 16 side, the material of the cathode layer 20 is preferably a material having a high reflectance with respect to the light from the organic function layer 18. As the material of the cathode layer 20, for example, an alkali metal, an alkaline earth metal, a transition metal, a group 13 element of the periodic table, or the like is used. As the cathode layer 20, for example, a transparent conductive electrode made of a conductive metal oxide, a conductive organic substance, or the like may be used. Specific examples of the conductive metal oxide include indium oxide, zinc oxide, tin oxide, ITO, and IZO, and examples of the conductive organic substance include polyaniline and its derivatives and polythiophene and its derivatives.

The thickness of the cathode layer 20 is set in consideration of electric conductivity, durability, and the like. The thickness of the cathode layer 20 is normally 10 nm to 10 $\mu$m, preferably 20 nm to 1 $\mu$m, and more preferably 50 nm to 500 nm. The cathode layer 20 can be formed similarly to the anode layer 16.

Examples of the method for forming the cathode layer 20 include a dry film forming method, a plating method, and a coating method. Examples of the dry film forming method and the coating method can be similar to those exemplified in the description of the anode layer formation step S11, respectively. The dry film forming method is preferable from the viewpoint of easily developing conductivity immediately after the film formation. The vacuum deposition method is preferable from the viewpoint of suppressing damage to the light-emitting layer.

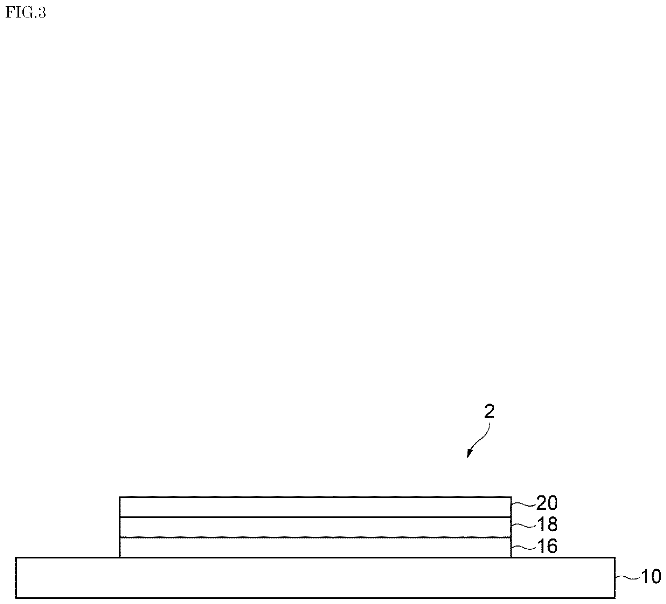

An organic EL device 2 (See Fig. 3) is formed in each device formation area DA by undergoing the cathode layer formation step S13. The organic EL device 2 includes the flexible film 10, the anode layer 16 formed on the flexible film 10, the organic function layer 18 formed on the anode layer 16, and the cathode layer 20 formed on the organic function layer 18. Therefore, the organic EL device 2 having a product size can be obtained by performing the division step of dividing the flexible film 10 for each device formation area DA.

The organic EL device 2 may include a sealing member that seals at least the organic function layer 18. The sealing member is stuck to the flexible film 10 and the structure (anode layer, organic function layer, and cathode layer) on the flexible film 10. The sealing member has a moisture barrier function that prevents moisture from entering the organic function layer 18. The sealing member may have a gas barrier function.

In a mode where the organic EL device 2 includes the sealing member, the stick step of sticking the sealing member to the flexible film 10 (i.e., a flexible film with a cathode layer) having undergone the cathode layer formation step S13 is only required to be performed between the cathode layer formation step S13 and the division step. In this stick step, for example, a long sealing member is stuck to the flexible film with the cathode layer. The size and stick position of the sealing member is only required to be set so that electric power can be supplied to the organic EL device 2.

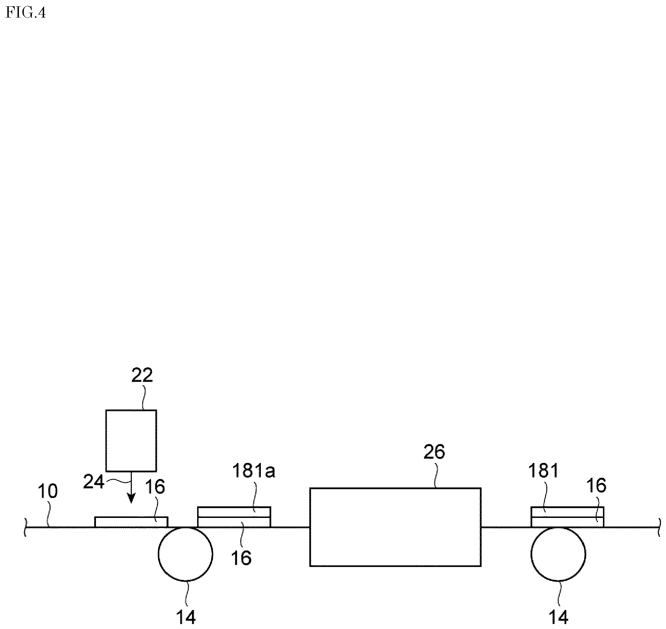

Next, the organic function layer formation step S12 will be described in detail. Fig. 4 is a view schematically showing the coating layer formation step and the heating step included in the organic function layer formation step S12. At least one function layer included in the organic function layer 18 is referred to as a function layer 181, and a method for forming the function layer 181 will be described. Here, for simplification of the description, an example of a case of forming the function layer 181 in contact with the anode layer 16 as shown in Fig. 4 will be described unless otherwise stated.

First, a coating layer 181a is formed on the anode layer 16 by the coating method (coating layer formation step). Fig. 4 shows a mode of forming the coating layer 181a by the ink-jet printing method as an example of the coating method. Specifically, a coating liquid (e.g., ink) 24 in which the material of the function layer 181 to be formed is dissolved in a solvent is dropped from an ink-jet apparatus 22 onto the anode layer 16 to form the coating layer 181a. In the present description, the coating layer is a film of a coating liquid before dried and solidified. Next, the coating layer 181a is heated and dried in a heating furnace 26 provided on the conveying path of the flexible film 10 to obtain the function layer 181 (heating step). Therefore, the organic function layer formation step S12 includes the above-described coating layer formation step and the above-described heating step.

In the case where another function layer has already been formed between the anode layer 16 and the function layer 181 to be formed, the other function layer described above may be used as a base layer and the coating layer 181a may be formed on the base layer, in the coating layer formation step.

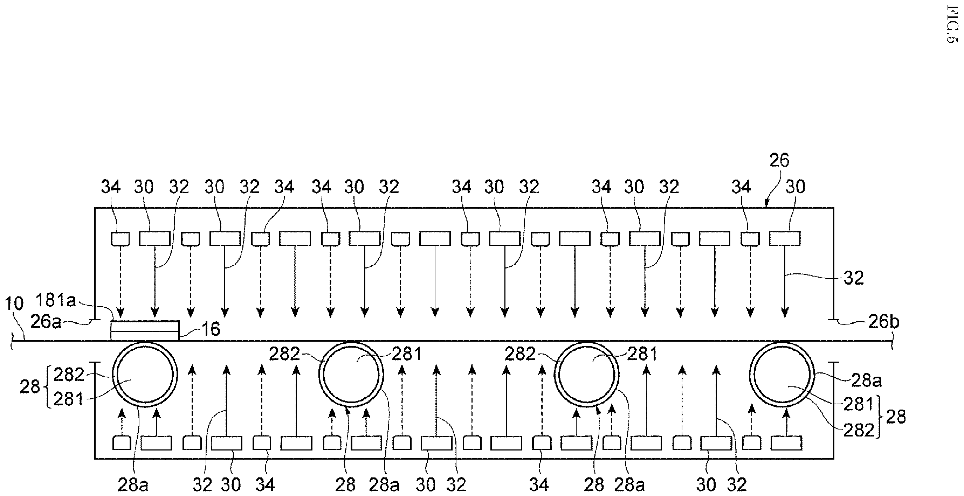

Fig. 5 is a view for explaining the heating step. In the heating step, the flexible film 10 having undergone the coating layer formation step is carried into the heating furnace 26 from a carry-in port 26a of the heating furnace 26. Fig. 5 illustrates a set of the anode layer 16 and the coating layer 181a. However, as described above, a plurality of anode layers 16 is discretely provided in the longitudinal direction of the flexible film 10, and the coating layer 181a is formed on each anode layer 16.

In the heating furnace 26, the carried-in flexible film 10 is conveyed by a conveyance roll 28 provided in the heating furnace 26. The coating layer 181a is heated and dried by irradiating an infrared ray 32 from an infrared irradiation part 30 disposed in the heating furnace 26 while conveying the flexible film 10 in the longitudinal direction of the flexible film 10. Thereafter, the flexible film 10 is continuously carried out of a carry-out port 26b.

In order to heat the coating layer 181a, the infrared irradiation part 30 outputs the infrared ray 32 including infrared ray in the wavelength range of 3 $\mu$m to 10 $\mu$m. An example of the infrared irradiation part 30 is an infrared heater. In the heating furnace 26, a plurality of the infrared irradiation parts 30 is disposed along the conveyance direction. As shown in Fig. 5, the infrared irradiation parts 30 may be disposed on both sides in the thickness direction of the flexible film 10, or may be disposed only on the side opposite to the coating layer 181a, for example.

As shown in Fig. 5, the conveyance roll 28 has a metal roll body 281 and a coating layer 282 provided on the surface of the roll body 281. An example of the material of the roll body 281 is stainless steel (SUS). The material of the coating layer 282 is an infrared absorbing material. Therefore, the material of a surface 28a of the conveyance roll 28 is an infrared absorbing material.

The infrared absorbing material absorbs the infrared ray 32 output from the infrared irradiation part 30. The average absorption rate of infrared rays in the wavelength range of 3 $\mu$m to 10 $\mu$m in the infrared absorbing material is 0.8 or more. An example of the infrared absorbing material is an inorganic oxide, and an example of the inorganic oxide is alumina.

Where the average absorption rate is $\alpha$, the average absorption rate $\alpha$ in a predetermined wavelength range is a value calculated by the following expression.

[Expression 1]

$$\alpha = \frac{\sum\limits_{\lambda=\lambda_1}^{\lambda=\lambda_2} k(\lambda)}{\lambda_2 - \lambda_1 + 1}$$

In the expression, $\lambda$ is a wavelength within the predetermined wavelength range, $k(\lambda)$ is an absorption rate at the wavelength $\lambda$, $\lambda_1$ is a lower limit value of the predetermined wavelength range, and $\lambda_2$ is an upper limit value of the predetermined wavelength range. Therefore, when the predetermined wavelength range is in the range of 3 $\mu$m to 10 $\mu$m, $\lambda_1$ is 3 $\mu$m and $\lambda_2$ is 10 $\mu$m. As a method for measuring the absorption rate of the wavelength $\lambda$, there is a measurement by an apparatus compliant with "JIS K 0117:2000 General rules for infrared spectrophotometric analysis", and in particular, a method using a Fourier transform infrared spectrophotometer, to which a Fourier transform is applied, is preferable.

In order to ventilate the inside of the heating furnace 26 and to efficiently discharge the solvent, an air nozzle 34 that outputs air as shown by a broken line may be disposed in the heating furnace 26.

In the heating step, the intensity, conveyance speed, and the like of the infrared ray 32 from the infrared irradiation part 30 are only required to be adjusted so that the coating layer 181a is heated and dried in the heating furnace 26. In the heating step, the flexible film 10 may also be heated to 100°C or higher. In the heating step, the wind velocity in an environment within 10 mm from the surface (surface on which the first electrode layer is formed) 10a (See Fig. 1) of the flexible film 10 is preferably 0.1 m/s or less.

The ink-jet printing method has been explained as an example of the coating method for use in the coating layer formation step. However, the coating layer 181a may be formed by a coating method other than the ink-jet printing method described in the anode layer formation step S11.

In the mode where the organic function layer 18 has a plurality of function layers, at least one function layer is only required to be formed in the coating layer formation step and the heating step. In other words, in a mode where the organic function layer 18 has a plurality of function layers, the organic function layer may have a function layer formed by a known forming method. For example, the electron injection layer may be formed by a vacuum deposition method.

The method for manufacturing the organic EL device 2 has the heating step when forming at least one function layer 181 included in the organic function layer 18. In the heating step, the infrared ray 32 is used as a method for heating the coating layer 181a. Therefore, a wind ripple (film thickness unevenness) is less likely to occur on the coating layer 181a as compared with the case of using warm air. Furthermore, the material of the surface 28a of the conveyance roll 28 is an infrared absorbing material whose average absorption rate of infrared rays in the wavelength range of 3 $\mu$m to 10 $\mu$m in the infrared absorbing material is 0.8 or more. Due to this, in the heating step, the infrared ray 32 irradiated from the infrared irradiation part 30 is absorbed by the infrared absorbing material, and hence the surface 28a of the conveyance roll 28 gets warmer than in the case where the surface 28a of the conveyance roll 28 does not absorb the infrared ray 32. When the surface 28a of the conveyance roll 28 is warmed, even if the flexible film 10 is in contact with the conveyance roll 28, the temperature drop of the contact portion can be suppressed, and hence the occurrence of twisting and wrinkling of the flexible film 10 accompanying the temperature drop can be prevented. Therefore, the coating layer 181a on the flexible film 10 is less likely to have film thickness unevenness, and the function layer 181 can be formed to a desired thickness with high accuracy, and hence deterioration of the characteristics of the organic EL device 2 can be prevented. For example, light emission unevenness can be prevented.

In the heating step, since the conveyance roll 28 conveys the flexible film 10 in the heating furnace 26, the flexible film 10 can be prevented from sagging. Therefore, the heating furnace 26 can be enlarged. For example, the length of the heating furnace 26 along the conveyance direction can be increased. Even if the heating furnace 26 is elongated, the coating layer 181a can be heated by disposing the infrared irradiation part 30, and furthermore, the heating temperature of the coating layer 181a can be raised depending on the strength of the infrared ray 32 or the like. As a result, the productivity of the organic EL device 2 can be improved.

In the heating step, the flexible film 10 is conveyed by using the conveyance roll 28, instead of being floated with, for example, gas when conveyed. This can also prevent the wind ripple by the gas for floating the flexible film 10 from being generated.

Since the surface 28a of the conveyance roll 28 is heated by the infrared ray 32 for used in heating of the coating layer 181a, the operation cost can be reduced more than in the case of using a heat roll, for example.

Normally, in the case of conveying the flexible film 10 by the conveyance roll 14 and the conveyance roll 28 as in the roll-to-roll method, the processing accuracy (accuracy known as cylindricity, straightness, roundness, or the like) of the roll tends to be required at a high level. In the mode where the conveyance roll 28 has the roll body 281 and the coating layer 282, the processing accuracy of the conveyance roll 28 can be easily maintained by forming the roll body 281 with the same processing accuracy as in the conventional manner. Furthermore, normally, the conveyance roll 28 can be manufactured by coating the infrared absorbing material onto the metal conveyance roll used in the roll-to-roll method, and hence the conveyance roll 28 can be easily prepared.

Furthermore, in the mode where the infrared absorbing material is an inorganic oxide, the durability is improved more than in the case of using plastic, and the processing accuracy is easily obtained.

When the temperature of the flexible film 10 becomes 100°C or higher in the heating step, the above-described twisting, wrinkling, and the like tend to occur as the temperature drops. Therefore, the method for manufacturing the organic EL device having the heating step capable of preventing the temperature drop is effective for the case where the temperature of the flexible film 10 becomes 100 °C or higher in the heating step. Normally, the temperature of the flexible film 10 tends to be 100°C or higher when the coating layer 181a is heated and dried.

In the ink-jet printing method, the viscosity of the ink can normally be set low. Therefore, for example, the thickness of the coating layer is susceptible to the twisting and wrinkling of the flexible film. In the above-described heating step of the method for manufacturing the organic EL device, the above-described twisting, wrinkling, and the like can be suppressed, and hence it is effective for the mode of forming the coating layer by the ink-jet printing method.

Next, with reference to experiment results, the operations and effects in the case where of using the conveyance roll 28 in the heating step will be further described.

(Experiment example 1)

In the experiment example 1, the conveyance roll 28 that was used was formed by thermal spraying alumina (average absorption rate of infrared rays in the wavelength range of 3 $\mu$m to 10 $\mu$m: 0.82) onto the surface of a metal roll (roll body) and coating the surface of the metal roll. An infrared heater was used for the infrared irradiation part 30, and the temperature of the infrared heater was set to 160°C. In the experiment example 1, a PEN film having a thickness of 100 μm was used as the flexible film 10, and a light-emitting layer was formed as the function layer 181 on the flexible film 10. Specifically, after the coating layer 181a was formed by the ink-jet printing method, the coating layer 181a was heated and dried by infrared rays while conveying the flexible film 10 at a conveyance speed of 1 m/min in the heating furnace 26, thereby obtaining the function layer 181. At that time, a thermometer was attached to the surface of the flexible film 10 to measure the temperature of the flexible film 10 during conveyance.

As a result, in the heating furnace 26, the flexible film 10 was substantially maintained at 150°C, and any rapid temperature change was not observed even in the portion in contact with the conveyance roll 28. More specifically, any temperature change of 1°C or more was not observed. Furthermore, no wrinkles were observed in the flexible film 10 carried out of the heating furnace 26, and no film thickness unevenness was observed in the obtained function layer 181.

(Experiment example 2)

The experiment example 2 is a comparative experiment of the experiment example 1. The experiment example 2 was conducted in the same manner as the experiment example 1 except that a metal roll whose surface is also made of a metal was used in place of the conveyance roll 28 used in the experiment example 1. As a result, a temperature drop of 10°C or more occurred at the contact portion of the flexible film 10 with the metal roll. Remarkable wrinkles were observed in the flexible film 10 carried out of the heating furnace, and film thickness unevenness was observed in the obtained function layer.

As understood from the comparison between the experiment example 1 and the experiment example 2, it is possible to prevent the temperature drop at the roll contact portion by using the conveyance roll 28 having the surface 28a made of an infrared absorbing material when the coating layer 181a is heated and dried by irradiation of infrared rays. As a result, wrinkles of the flexible film 10 and film thickness unevenness in the function layer to be formed can be prevented, and the function layer of a desired thickness can be easily realized.

Various embodiments and modifications of the present invention have been described above. However, the present invention is not limited to the various embodiments and modifications having been exemplified, but is intended to include the scope indicated by the claims, and intended to include all modifications made within the meaning and scope equivalent to the claims.

In the method for manufacturing the organic EL device illustrated in Fig. 2, the anode layer formation step is performed. However, a flexible film having an anode layer formed in advance may be used. That is, the anode layer formation step may not be performed.

In the method for manufacturing the organic EL device illustrated in Fig. 2, the entire process up to the anode layer formation step, the organic function layer formation step, and the cathode layer formation step is performed by the roll-to-roll method. However, it is sufficient that the heating step shown in Fig. 5 is performed at least in the roll-to-roll method. Normally, the coating layer formation step and the heating step can be continuously performed by the roll-to-roll method.

The anode layer has been exemplified as the first electrode layer, and the cathode layer has been exemplified as the second electrode layer. However, the first electrode layer may be a cathode layer and the second electrode layer may be an anode layer. That is, the cathode layer may be disposed on the flexible film side. The organic EL device to be manufactured may be a top-emission type device.

In the above embodiment, a method for manufacturing an organic EL device, which is an example of an organic electronic device, has been described. However, the present invention is also applicable to the manufacture of organic electronic devices such as organic photodetectors, organic thin film solar cells, and organic transistors, in addition to organic EL devices.

DESCRIPTION OF REFERENCE SIGNS

2...Organic EL device (Organic electronic device)
10...Flexible film
10a...Surface (Surface on which first electrode layer of flexible film is formed)
16...Anode layer (first electrode layer)
18...Organic function layer
20...Cathode layer (second electrode layer)
26...Heating furnace
28... Conveyance roll (Roll)
28a...Surface (Surface of roll)
30...Infrared irradiation part
32...Infrared ray
181...Function layer
181a...coating layer
281...Roll body
282...Coating layer

**Claims**

1.  A method for manufacturing an organic electronic device, comprising:

    an organic function layer formation step of forming an organic function layer having a monolayer structure or a multilayer structure on a first electrode layer formed on a long flexible film; and

a second electrode layer formation step of forming a second electrode layer on the organic function layer, wherein
the organic function layer formation step includes

a coating layer formation step of forming a coating layer by a coating method, and
a heating step of heating the coating layer with infrared rays to obtain a function layer, while conveying the flexible film by a roll whose surface is made of an infrared absorbing material, and

an average absorption rate of infrared rays in a wavelength range of 3 $\mu$m to 10 $\mu$m in the infrared absorbing material is 0.8 or more.

2. The method for manufacturing the organic electronic device according to claim 1, wherein
the roll has

a metal roll body and
a coating layer coated on a surface of the roll body, wherein a material of the coating layer is the infrared absorbing material.

3. The method for manufacturing the organic electronic device according to claim 1 or 2, wherein in the heating step, the flexible film is heated to 100°C or higher.

4. The method for manufacturing the organic electronic device according to any one of claims 1 to 3, wherein in the heating step, a wind velocity within 10 mm from a surface of the flexible film on which the first electrode layer is formed is 0.1 m/s or less.

5. The method for manufacturing the organic electronic device according to any one of claims 1 to 4, wherein the infrared absorbing material is an inorganic oxide.

6. The method for manufacturing the organic electronic device according to claim 5, wherein the inorganic oxide is alumina.

7. The method for manufacturing the organic electronic device according to any one of claims 1 to 6, wherein the coating method is an ink-jet printing method.

FIG.1

FIG.2

FIG.3

FIG.4

FIG.5

| | **INTERNATIONAL SEARCH REPORT** | International application No. |
|---|---|---|
| | | PCT/JP2019/028711 |

**A. CLASSIFICATION OF SUBJECT MATTER**
Int.Cl. H05B33/10(2006.01)i, H01L51/50(2006.01)i, H05B33/02(2006.01)i
According to International Patent Classification (IPC) or to both national classification and IPC

**B. FIELDS SEARCHED**

Minimum documentation searched (classification system followed by classification symbols)
Int.Cl.    H05B33/10, H01L51/50, H05B33/02, H01L3/04, B05C5/00, G02B5/30,
           G02B1/10

| Documentation searched other than minimum documentation to the extent that such documents are included in the fields searched | |
|---|---|
| Published examined utility model applications of Japan | 1922–1996 |
| Published unexamined utility model applications of Japan | 1971–2019 |
| Registered utility model specifications of Japan | 1996–2019 |
| Published registered utility model applications of Japan | 1994–2019 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2016/208597 A1 (SUMITOMO CHEMICAL CO., LTD.) 29 December 2016, paragraphs [0118]-[0130], fig. 6 & US 2018/0175298 A1, paragraphs [0149]-[0163], fig. 6 & EP 3313152 A1 & CN 10771087 4 A & KR 10-2018-0019146 A | 1-7 |
| A | JP 5-96722 A (CANON INC.) 20 April 1993, paragraphs [0014]-[0015], fig. 1 (Family: none) | 1-7 |

☒ Further documents are listed in the continuation of Box C.  ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 27 September 2019 (27.09.2019) | 08 October 2019 (08.10.2019) |

| Name and mailing address of the ISA/ | Authorized officer |
|---|---|
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

**INTERNATIONAL SEARCH REPORT**

International application No.

PCT/JP2019/028711

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2009-271419 A (PANASONIC CORP.) 19 November 2009, paragraphs [0027]-[0028], fig. 1 & US 2010/0247180 A1, paragraphs [0216]-[0218], fig. 10 & WO 2009/063626 A1 & EP 2222131 A1 & KR 10-2010-0085975 A & CN 101861758 A | 1-7 |
| A | JP 2013-238638 A (KONICA MINOLTA, INC.) 28 November 2013, paragraph [0023], fig. 2 (Family: none) | 1-7 |

Form PCT/ISA/210 (continuation of second sheet) (January 2015)

EP 3 829 267 A1

# REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2010090087 A